# EUROPEAN PATENT SPECIFICATION

(11) **EP 0 326 877 B1**
(45) Date of publication and mention of the grant of the patent: **05.04.1995**
(21) Application number: 89101007.6
(22) Date of filing: 20.01.1989
(51) Int. Cl.: H01L 29/78, H01L 27/10, G11C 17/00

(54) **Electrically-erasable, electrically-programmable read-only memory cell**
Elektrisch löschbare und programmierbare Nur-Lesespeicherzelle
Cellule de mémoire morte effaçable et programmable électriquement

(30) Priority: 05.02.1988 US 152789; 15.07.1988 US 219528
(43) Date of publication of application: 09.08.1989
(73) Proprietor: TEXAS INSTRUMENTS INCORPORATED, Dallas Texas 75265 (US)
(72) Inventor: Gill, Manzur, Rosharon Texas 77583 (US); Lin, Sung-Wei, Houston Texas 77083 (US); D'Arrigo, Sebastiano, Houston Texas 77083 (US)
(74) Representative: Leiser, Gottfried, Dipl.-Ing.

(56) References cited:
- EP-A- 0 105 802
- EP-A- 0 144 900
- WO-A-85/01146
- US-A- 4 258 466

## Description

### BACKGROUND OF THE INVENTION

This invention relates to semiconductor memory devices, and more particularly to an electrically-erasable, electrically-programmable floating-gate memory cell according to the precharacterizing part of claim 1.

EPROMs, or electrically-programmable ROMs, are field-effect devices with a floating-gate structure. An EPROM floating gate is programmed by applying proper voltages to the source, drain and control gate of each cell, causing high current through the source-drain path and charging of the floating gate by hot electrons. The EPROM type of device is erased by ultraviolet light, which requires a device package having a quartz window above the semiconductor chip. Packages of this type are expensive in comparison with the plastic packages ordinarily used for other memory devices such as DRAMs (dynamic-random-access-memories). For this reason, EPROMs are generally more expensive than plastic-packaged devices.

EEPROMs, or electrically-erasable, electrically-programmable ROMs, have been manufactured by various processes, usually requiring a much larger cell size than standard EPROMs and requiring more complex manufacturing processes. EEPROMs can be mounted in opaque plastic packages that reduce the packaging cost. Nevertheless, EEPROMs have been more expensive on a per-bit basis, in comparison with EPROMs, due to larger cell size and to more complex manufacturing processes.

Flash EEPROMs have the advantage of smaller cell size in comparison with standard EEPROMs because the cells are not erased individually. Instead, the array of cells is erased in bulk.

Currently available flash EEPROMs require two power supplies, one for programming and erasing and another for reading. Typically, a 12-volt power supply is used for programming and erasing and a 5-volt power supply is used during read operations. It is desirable, however, to employ a single relatively low-voltage supply for all of the programming, erasing and reading operations.

US-A-4,258,466 shows a contactless floating gate electrically programmable memory cell and EP-A-0 105 802 discloses an electrically programmable and erasable floating-gate memory cell based on tunnelling according to the preamble of claim 1.

It is the object of this invention to provide an electrically programmable memory, or an electrically-erasable and electrically-programmable memory, that uses a single, relatively low-voltage, external supply for both programming and erasing, allowing the memory device to be compatible with on-board or in-circuit programming where systems have a single external power supply. It is also an object to provide a non-volatile memory that can be packaged in a less expensive opaque plastic package. An additional object is to provide an electrically-programmable memory that does not require high current for programming. A further object is to provide an improved method for making an EEPROM or a "flash" EEPROM, as well as an improved cell for an EEPROM or a "flash" EEPROM, the manufactured cell using P+ implanted regions for isolation between wordlines, using thick oxide for isolation of between bitlines, and providing improved coupling between the control gate and the floating gate during programming and erasing operations.

### SUMMARY OF THE INVENTION

The above objects are achieved by the memory cell having the features of the characterizing part of claim 1.

In accordance with one embodiment of the invention, an electrically-erasable PROM or an EEPROM is constructed using an enhancement transistor merged with a floating-gate transistor. The floating-gate transistor has a small tunnel window adjacent the source in a contact-free cell layout, enhancing ease of manufacture and reducing cell size. The device has bitlines (source/drain regions) that are buried beneath relatively thick silicon oxide, allowing a favorable ratio of control gate to floating gate capacitance. Programming and erasing are accomplished using the tunnel window area near the source. The window has a thinner dielectric than the remainder of the floating gate to allow Fowler-Nordheim tunneling. By using dedicated drain and ground lines, rather than a virtual-ground layout, and by using thick oxide for isolation between the bitlines of adjacent cells, the floating gate can extend onto adjacent bitlines and isolation areas, resulting in a favorable coupling ratio. The isolation between adjacent wordlines can be by a P+ implanted region, similar to a channel-stop. Use of the P+ implanted region permits smaller cell size.

### BRIEF DESCRIPTION OF THE DRAWINGS

The novel features believed characteristic of the invention are set forth in the appended claims. The invention itself, however, as well as other objects and advantages thereof, will be best understood by reference to the following description of particular embodiments thereof, when read in conjunction with the accompanying drawings, in which:
Figure 1 is a plan view of a small part of a semiconductor chip having memory cells according to one embodiment;
Figures 2a-2e are elevation views in section of the semiconductor device of Figure 1, taken along the lines a-a, b-b, c-c, d-d, and e-e of Figure 1;
Figure 3 is an electrical schematic diagram of the cells of Figures 1 and 2a-2e; and
Figures 4a-4d are elevation views in section, corresponding to Figure 2a, of the device of Figures 1 and 2a-2e at successive stages in the manufacture thereof.

### DETAILED DESCRIPTION OF SPECIFIC EMBODIMENT

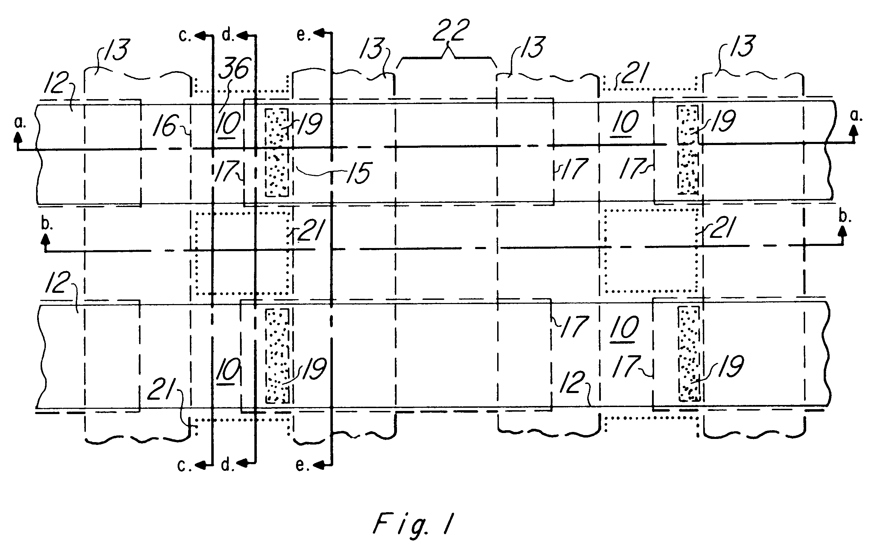

Referring now to Figures 1, 2a-2e and 3, an array of electrically-erasable, electrically-programmable memory cells 10 is shown formed in a face of a silicon substrate 11. Only a very small part of the substrate is shown in the Figures, it being understood that these cells are part of an array of a very large number of such cells. A number of wordlines/control gates 12 are formed by second-level polycrystalline silicon (polysilicon) strips extending along the face of the substrate 11, and bitlines 13 are formed beneath thick thermal silicon oxide layers 14 in the face. These buried bitlines 13 create the source region 15 and the drain region 16 for each of the cells 10. A floating gate 17 for each cell is formed by a first-level polysilicon layer extending across about half of a cell 10 and across one bitline and extending over onto another adjacent bitline 13. Two "horizontal" or X-direction edges of the floating gate 17 for a cell are aligned with the edges of a wordline/control gates 12. A tunnel area 19 for programming and erasing is formed near the source 15 of each cell 10, and silicon oxide at this window 19 is thinner, about 10nm (100A), compared to the dielectric coating 20 of about 35nm (350A) for the remainder of the channel beneath the floating gate 17. Programming and erasing can be performed using a relatively low externally-applied voltage when the structure of the invention is employed, with Fowler-Nordheim tunnelling requiring very little current. The coupling between layer 12 and layer 17, compared to coupling between floating gate 17 and source 15 or substrate 11, is more favorable because the floating gate extends out across the bitlines 13 and isolating area 22. Therefore, a larger fraction of the programming/erasing voltages applied between control gate 12 and source 15 will appear between floating gate 17 and source 15. The cell 10 is referred to as "contact-free" in that no source/drain contact is needed in the vicinity of cell itself.

The regions between wordlines are implanted with P-type impurity to create doped isolation regions 21 that isolate cells from one another in the Y-direction. Strips 22 of LOCOS thick field oxide separate bitlines 13 between cells in the X-direction. Note that the array of cells is not of the "virtual-ground-circuit" type because there are two bitlines 13 or column lines (one for source, one for drain) for each column (Y-direction) of cells, one bitline being a dedicated ground, and one being the data input/output and sense line.

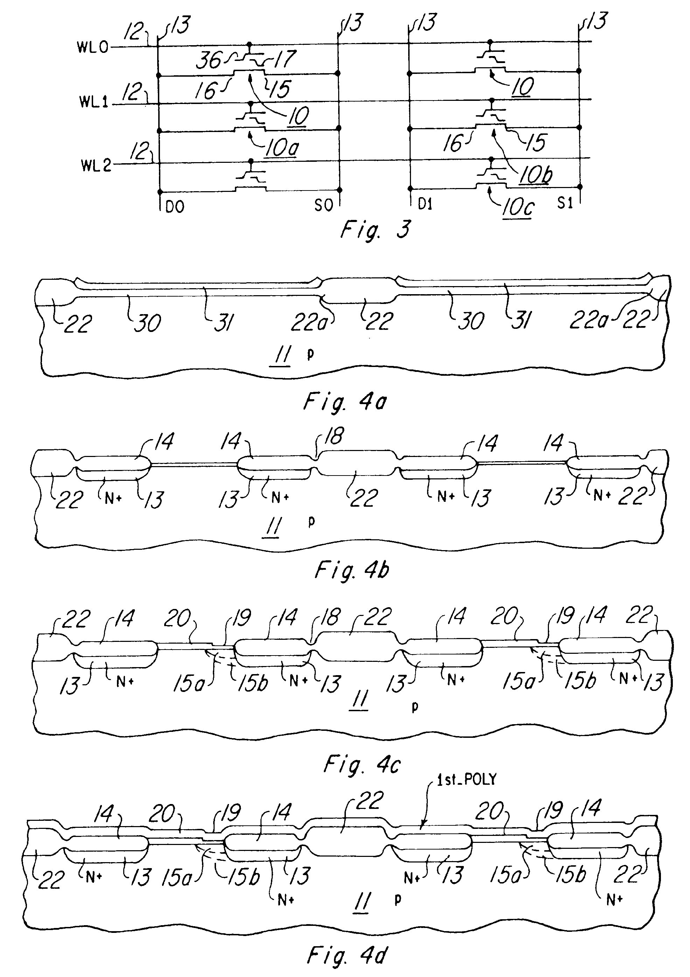

The EEPROM cells of Figures 1, 2a-2e and 3 are programmed with a voltage Vpp applied to the selected wordline 12 of about +16v to +18v with respect to the source 15 of the selected cell 10. The source 15 of the selected cell 10 is at ground or other reference voltage. For example, in Figure 3, if the cell 10a is selected to be programmed, then the wordline labelled WL1 is brought to +Vpp and the source labelled S0 is grounded. The voltage +Vpp can be internally generated with charge pumps on the chip, with the externally-applied supply voltage having a relatively small positive potential, perhaps +5v. The selected drain 16 (labelled D0 in this example) is allowed to float under these programming conditions so there is little or no current through the source-drain path. The Fowler-Nordheim tunneling across the tunnel oxide 19 (with thickness of about 10nm (100A)) charges the floating gate 17 of the selected cell 10a, resulting in a shift in threshold voltage of perhaps 3-6 volts after a programming pulse approximately 10 milliseconds in length.

A selected cell 10 is erased by applying a voltage Vee (internally generated) of perhaps -10v on the selected wordline/control gate 12 and a voltage of about +5v on the source 15 or bitline 13. The drain 16 (the other bitline 13) is allowed to float. During the erasure tunnelling, electrons flow from the floating gate 17 to the source 15 because the control gate 12 is negative with respect to the source 15.

When a "flash erase" is performed (all cells erased at one time), all of the drains 16 in the array are allowed to float, all of the sources 15 are at potential Vdd, and all of the wordlines/control gates 12 are at potential -Vee.

To prevent a write-disturb condition during the programming example (cell 10a being programmed), all of the sources 15 of non-selected cells, such as cell 10b, on the same wordline WL1 of Figure 3 are held at a voltage Vbl, which is in the approximate range of 5-7 volts positive. The drains 16 of non-selected cells such as 10b are allowed to float, preventing any source-drain currents from flowing. The voltage Vbl applied to the sources 15 prevents the electric fields across the tunnel oxides 19 of the cells, including example cell 10b, from becoming large enough to charge the floating gates 17.

Another condition to be avoided is the "bitline-stress", or deprogramming, associated with a high electric field across the tunnel oxide of a programmed cell when the source of the cell is at a potential near Vbl. To prevent this bitline stress condition, the non-selected wordlines/ control gates WL0 and WL2 of Figure 3 are held at a voltage in the approximate range of 5-10 volts positive, thereby reducing the electric field across the tunnel oxide 19 of each non-selected programmed cell. A programmed cell such as 10c has a potential of about -2 to -4 volts on its floating gate, so when the voltage Vbl on the source S1 of such a cell 10c is in the range of 5-7 volts positive, the field across the tunnel oxide 19 could tend to deprogram the cell, but with voltage in the range of 5-10 volts positive on the wordline WL2, the field is reduced. This voltage on the wordline/control gate WL2 is not so great, however, as to cause a voltage threshold Vt change in a cell having no charge on its floating gate.

The cells described above can be read at low voltage. For example, a row of cells may be read by placing +3v on the selected wordline/control gate, zero volts on all of the other wordlines/control gates, zero volts on all of the sources, and +1.5v on all of the drains. In this condition, the source-drain path of a cell will be conductive in an erased or a non-programmed state (a cell with zero charge on its floating gate), i.e., storing a logic one. A programmed cell (programmed to the high-voltage-threshold state, with a negative charge on the floating gate) will not conduct, i.e., storing a logic zero.

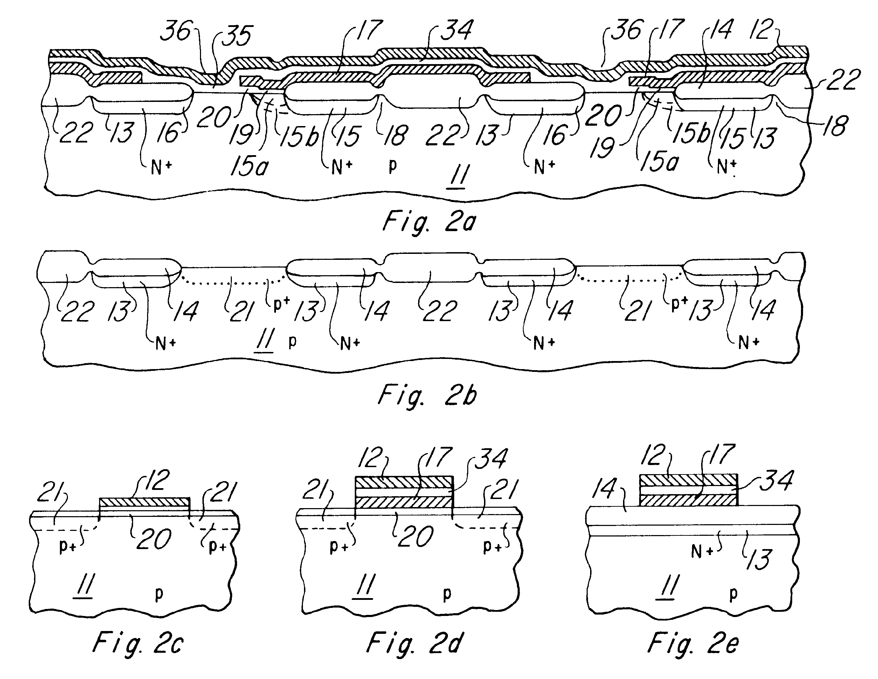

A method for making the device of Figures 1 and 2a-2e will be described in reference to Figures 4a-4d. The starting material is a slice of P-type silicon of which the substrate 11 is only a very small portion. The slice is perhaps 6 inches in diameter, while the portion shown in Figure 1 is only a few microns wide. A number of process steps would be performed to create transistors peripheral to the array, and these will not be discussed here. For example, the memory device may be of the complementary field-effect type in which N-wells and P-wells are formed in the substrate 11 as part of a prior process to create peripheral transistors. The first step related to the cell array of the invention is applying oxide and silicon nitride coatings 30 and 31 as seen in Figure 4a, and patterning these coatings using photoresist to leave nitride over what will be the channel regions, the sources and drains, and bitlines 13 while exposing the areas where the thick field oxide 22 is to be formed. A boron implant at about 8x10¹² cm⁻² dosage is performed to create a P+ channel stop region beneath the field oxide 22. Then the field oxide 22 is grown to a thickness of about 900nm (9000A) by exposing to steam at about 900°C for several hours. The thermal oxide grows beneath the edges of the nitride 31, creating a "bird's beak" 22a instead of a sharp transition.

Turning now to Figure 4b, the nitride 31 is removed and, in the area where the bitlines 13 are to be formed, an arsenic implant is performed at a dosage of about 6x10¹⁵ cm⁻² at 135 KeV, using photoresist as an implant mask, to create the source/drain regions and bitlines. Next, another thermal oxide 14 is grown on the face to a thickness of about 250 to 350nm (2500 to 3500A) over the source/drain regions and bitlines 13, during which time a thermal oxide of about 30nm (300A) will grow over the channel areas (due to the differential oxidation occurring when heavily-doped and lightly-doped silicon are exposed to oxidation at the same time), to create the oxide layers 14 above the source/drain regions and bitlines 13. This oxidation is in steam at about 800 to 900°C. At the transition areas 18 where the bird's beak 22a has been formed, the edge of the originally-formed thermal oxide has masked the arsenic implant so the concentration is lower and so the oxide growth in that area is less than that of the oxide 14 or the oxide 22.

Referring now to Figure 4c, a window 19 (also seen in Figure 1) is opened in the gate oxide 20. This is done using photoresist as a mask, and etching through the oxide 20 to the bare silicon, then growing a thin oxide to form the tunnel window 19. During oxidation of tunnel window 19, oxide 20 over the channel region will grow to approximately 35nm (350A.).

Referring now to Figure 2a, first polysilicon layer is now applied to the face of the silicon slice, doped N+, and a coating 34 of oxide, or oxide-nitride-oxide, is applied to separate the two polysilicon levels. The first-level polysilicon is defined using photoresist to leave elongated strips in the Y-direction, parts of which will become the floating gates 17. An oxidation, performed after the first-level polysilicon is defined, covers the edges of first-level polysilicon, and also creates the gate oxide 35 for the series enhancement transistor 36. A second polysilicon layer is deposited, doped N+, and patterned using photoresist to create the wordlines/control gates 12. At the same time as the wordlines/control gates 12 are defined, the edges of the first-level polysilicon are etched, so that the elongated X-direction edges of the floating gates are self-aligned with the edges of the control gates.

A self-aligned ion implant step is performed, using the stacked polysilicon-1 and polysilicon-2 layers of wordlines/control gates 12 and floating gates 17 as a mask, to create the isolating regions 21. For this purpose, boron is implanted at a dosage of about 10¹² cm⁻² at about 70 KeV. After annealing and oxidation, this implant produces the P+ regions 21 very much like channel stop implants beneath field oxide.

The memory arrays using the cell 10 of this invention may utilize less area on an integrated circuit chip in comparison to other memory arrays.

Optionally, the junction profile on the channel side of source 15 may be tailored to make certain that it terminates under the 350A gate oxide 20, extending over the entire lower surface of window 19 and thereby maximizing the field-plate breakdown voltage of the source junction. Extension 15a or 15b of source 15 extends past the window 19 area and greatly increases the possibility that erasure will be by purely Fowler-Nordheim tunneling and not by hot carriers. For example, extension 15a may be formed to extend source 15 completely under the lower surface of window 19 by implanting a N-type impurity in window 19 prior to or after growing the 10nm (100A) coating. An alternative procedure is to include phosphorus as one of the doping materials used to form source 15, then subjecting the slice to a temperature cycle that causes the phosphorus to diffuse laterally under window 19 to form extension 15b.

## Claims

1. An electrically-erasable, electrically programmable, floating-gate memory cell (10), comprising:
a source region (15) and a drain region (16) formed in the face of a semiconductor body (11), each of said regions (15, 16) being a heavily doped region of conductivity type opposite that of underlying material of said body (11), said source region (15) being spaced from said drain region (16) on said face by a channel area,
a floating gate (17) over part of said channel area and extending onto a relatively thick layer of silicon oxide (14) over the source region (15), the floating-gate (17) being separated from the channel area of said face by a gate insulator (20), and
a control gate (12) extending laterally along said face, over said floating-gate (17) and over said source and drain regions (15, 16), the control gate (12) being separated from the floating gate (17) insulator coating (34), the control gate being laterally aligned with edges of said floating gate (17); characterized in that
each of said regions (15) (16) is buried under said silicon oxide (14) on said face,
said floating gate (17) overlies a tunnel area (19) near said source region (15), the thickness of said gate insulator (20) at said tunnel area (19) being less than the thickness of said gate insulator (20) beneath other areas of said floating gate (17) to permit tunnelling, and
said cell (10) being laterally isolated by thick field oxide regions (22);
wherein said source and drain regions (15, 16) are included in bitlines.

2. A memory cell (10) according to claim 1 wherein said semiconductor body (11) is silicon, and said source and drain regions (15, 16) are N+ type.

3. A memory cell (10) according to claim 1 or 2 wherein said floating gate (17) and said control gate (12) are polycrystalline silicon layers.

4. A memory cell (10) according to any preceding claim wherein said silicon oxide (14) is much thicker than said gate insulator coating (34) at other areas of the channel, and wherein said field oxide (22) is thicker than said silicon oxide (14).

5. A memory cell (10) according to any preceeding claim wherein said control gate (12) is part of an elongated wordline extending along said face, and wherein said source and drain regions (15, 16) are parts of elongated bitlines extending along said face perpendicular to said wordline.

6. A memory cell (10) according to any preceding claim wherein said tunnel area (19) is positioned between said source region (15) and said drain region (16) on said face.

7. A memory cell (10) according to any of claims 1 to 5 wherein said tunnel area (19) is positioned over at least part of said source region (15).

8. A memory cell (10) according to any of claims 1 to 5 wherein said tunnel area (19) is entirely positioned above said source region (15).

9. A memory cell as claimed in any preceding claim and wherein said floating gate extends to overlie said field oxide (22).

10. An array of memory cells, each of said cells being a memory cell as claimed in any preceding claim.

11. An array of memory cells as claimed in claim 10, wherein the floating gate (17) of a memory cell (10) overlies a bitline (13) of an adjacent cell.

12. An array of memory cells an claimed in claim 10 or claim 11, wherein a plurality of control gates (12) are arranged to form a contiguous wordline.

13. An array as claimed in claim 12, and wherein adjacent cells are isolated in a direction perpendicular to said wordline by implanted regions (21).

## Patentansprüche

1. Elektrisch löschbare, elektrisch programmierbare Speicherzelle (10) mit schwimmendem Gate, enthaltend:
eine Source-Zone (15) und eine Drain-Zone (16), die in der Fläche eines Halbleiterkörpers (11) gebildet sind, wobei jede dieser Zonen (15, 16) eine stark dotierte Zone mit einem den Leitungstyp des darunterliegenden Materials des Körpers (11) entgegengesetzten Leitungstyp ist, wobei die Source-Zone (15) um einen Kanalbereich im Abstand von der Drain-Zone (16) auf der Fläche liegt,
ein schwimmendes Gate (17) über einen Teil des Kanalbereichs mit Erstreckung auf eine relativ dicke Schicht aus Siliciumoxid (14) über der Source-Zone (15), wobei das schwimmende Gate (17) durch einen Gate-Isolator (20) von dem Kanalbereich der Fläche getrennt ist, und
ein Steuer-Gate (12), das sich seitlich längs der Fläche über dem schwimmenden Gate (17) und über den Source- und Drain-Zonen (15, 16) erstreckt, wobei das Steuer-Gate (12) durch einen Isolatorüberzug (34) von dem schwimmenden Gate (17) getrennt ist, wobei das Steuer-Gate seitlich auf die Ränder des schwimmenden Gates (17) ausgerichtet ist, dadurch gekennzeichnet, daß
jede der Zonen (15) (16) unter dem Siliciumoxid (14) auf der Fläche vergraben ist,
das schwimmende Gate (17) über einen Tunnelbereich (19) nahe der Source-Zone (15) liegt, wobei die Dicke des Gate-Isolators (20) an dem Tunnelbereich (19) geringer als die Dicke des Gate-Isolators (20) unterhalb anderer Bereiche des schwimmenden Gates (17) ist, um das Tunneln zu ermöglichen, und
die Zelle (10) seitlich durch dicke Feldoxidzonen (22) isoliert ist,
wobei die Source- und Drain-Zonen (15, 16) in Bitleitungen enthalten sind.

2. Speicherzelle (10) nach Anspruch 1, bei welcher der Halbleiterkörper (11) aus Silicium besteht und die Source- und Drain-Zonen (15, 16) vom N⁺-Typ sind.

3. Speicherzelle (10) nach Anspruch 1 oder 2, bei welcher das schwimmende Gate (17) und das Steuer-Gate (12) polykristalline Siliciumschichten sind.

4. Speicherzelle (10) nach einem der vorhergehenden Ansprüche, bei welcher das Siliciumoxid (14) viel dicker als der Gate-Isolator-Überzug (34) an anderen Bereichen des Kanals ist und bei welcher das Feldoxid (22) dicker als das Siliciumoxid (14) ist.

5. Speicherzelle (10) nach einem der vorhergehenden Ansprüche, bei welcher das Steuer-Gate (12) ein Teil einer länglichen Wortleitung ist, die längs der Fläche verläuft, und bei welcher die Source- und Drain-Zonen (15, 16) Teile länglicher Bitleitungen sind, die längs der Fläche senkrecht zu der Wortleitung verlaufen.

6. Speicherzelle (10) nach einem der vorhergehenden Ansprüche, bei welcher der Tunnelbereich (19) zwischen der Source-Zone (15) und der Drain-Zone (16) auf der Fläche angeordnet ist.

7. Speicherzelle (10) nach einem der Ansprüche 1 bis 5, bei welcher der Tunnelbereich (19) über wenigstens einen Teil der Source-Zone (15) angeordnet ist.

8. Speicherzelle (10) nach einem der Ansprüche 1 bis 5, bei welcher der Tunnelbereich (19) vollständig über der Source-Zone (15) angeordnet ist.

9. Speicherzelle nach einem der vorhergehenden Ansprüche, bei welcher sich das schwimmende Gate so erstreckt, daß es über dem Feldoxid (22) liegt.

10. Matrix aus Speicherzellen, wobei jede der Zellen eine Speicherzelle gemäß einem der vorhergehenden Ansprüche ist.

11. Matrix aus Speicherzellen nach Anspruch 10, bei welcher das schwimmende Gate (17) einer Speicherzelle (10) über einer Bitleitung (13) einer benachbarten Zelle liegt.

12. Matrix aus Speicherzellen nach Anspruch 10 oder Anspruch 11, bei welcher mehrere Steuer-Gates (12) so angeordnet sind, daß sie eine zusammenhängende Wortleitung bilden.

13. Matrix nach Anspruch 12, bei welcher benachbarte Speicherzellen in einer senkrecht zu der Wortleitung verlaufenden Richtung durch implantierte Zonen (21) isoliert sind.

## Revendications

1. Cellule de mémoire morte (10) à grille flottante, électriquement programmable et électriquement effaçable, comprenant :
une région de source (15) et une région de drain (16) formées dans la face d'un corps de semiconducteur (11), chacune desdites régions (15,16) étant une région fortement dopée d'un type de conductivité opposé à celui d'un matériau sous-jacent dudit corps (11), ladite région de source (15) étant espacée de ladite région de drain (16) sur ladite face par une zone de canal,
une grille flottante (17) recouvrant une partie de ladite zone de canal et s'étendant sur une couche relativement épaisse d'oxyde de silicium (14) au dessus de la région de source (15), la grille flottante (17) étant séparée de la zone de canal de ladite face par un isolant de grille (20), et
une grille de commande (12) s'étendant latéralement le long de ladite face, sur ladite grille flottante (17) et sur lesdites régions de source et de drain (15,16), la grille de commande (12) étant séparée de la grille flottante (17) par un revêtement isolant (34), la grille de commande étant latéralement alignée avec les bords de ladite grille flottante (17) ; caractérisée en ce que
chacune desdites régions (15,16) est enterrée sous ledit oxyde de silicium (14) sur ladite face,
ladite grille flottante (17) recouvrant une zone de tunnel (19) proche de ladite région de source (15), l'épaisseur dudit isolant de grille (20) au niveau de ladite zone de tunnel (19) étant inférieure à l'épaisseur dudit isolant de grille (20) au dessous des autres zones de ladite grille flottante (17) de manière à permettre la réalisation d'un tunnel, et
ladite cellule (10) étant isolée latéralement par des régions de couche d'oxyde épais (22) ;
dans laquelle lesdites régions de source et de drain (15,16) sont incluses dans des lignes de bits.

2. Cellule de mémoire (10) selon la revendication 1 dans laquelle ledit corps de semiconducteur (11) est du silicium, et lesdites régions de source et de drain (15,16) sont de type N+.

3. Cellule de mémoire (10) selon l'une des revendications 1 et 2 dans laquelle ladite grille flottante (17) et ladite grille de commande (12) sont des couches de silicium polycristallin.

4. Cellule de mémoire (10) selon l'une quelconque des revendications précédentes dans laquelle ledit oxyde de silicium (14) est plus épais que ledit revêtement (34) d'isolant de grille au niveau d'autres zones du canal, et dans laquelle ladite couche d'oxyde (22) est plus épaisse que ledit oxyde de silicium (14).

5. Cellule de mémoire (10) selon l'une quelconque des revendications précédentes dans laquelle ladite grille de commande (12) est une partie d'une ligne de mots allongée s'étendant le long de ladite face, et dans laquelle lesdites régions de source et de drain (15,16) font partie de lignes de bits allongées s'étendant le long de ladite face perpendiculaires à ladite ligne de mots.

6. Cellule de mémoire (10) selon l'une quelconque des revendications précédentes dans laquelle ladite zone de tunnel (19) est positionnées entre ladite région de source (15) et ladite région de drain (16) sur ladite face.

7. Cellule de mémoire (10) selon l'une quelconque des revendications 1 à 5 dans laquelle ladite zone de tunnel (19) est positionnée sur au moins une partie de ladite région de source (15).

8. Cellule de mémoire (10) selon l'une quelconque des revendications 1 à 5 dans laquelle ladite zone de tunnel (19) est entièrement positionnée au dessus de ladite région de source (15).

9. Cellule de mémoire (10) selon l'une quelconque des revendications précédentes et dans laquelle ladite grille flottante s'étend de manière à recouvrir ladite couche d'oxyde (22).

10. Réseau de cellules de mémoire, chacune desdites cellules étant une cellule de mémoire selon l'une quelconque des revendications précédentes.

11. Réseau de cellules de mémoire selon la revendication 10, dans lequel la grille flottante (17) d'une cellule de mémoire (10) recouvre une ligne de bits (13) d'une cellule adjacente.

12. Réseau de cellules de mémoire selon la revendication 10 ou la revendication 11, dans lequel une pluralité de grilles de commande (12) sont disposées de manière à former une ligne de mots continue.

13. Réseau selon la revendication 12, et dans lequel des cellules adjacentes sont isolées selon une direction perpendiculaire à ladite ligne de mots par des zones implantées (21).
